(19) Europäisches Patentamt
European Patent Office
Office européen des brevets

(11) **EP 3 104 488 A1**

(12) **EUROPEAN PATENT APPLICATION**
published in accordance with Art. 153(4) EPC

(43) Date of publication:
**14.12.2016 Bulletin 2016/50**

(51) Int Cl.:
*H02J 3/32* (2006.01)      *H02J 13/00* (2006.01)

(21) Application number: **14882025.1**

(22) Date of filing: **13.11.2014**

(86) International application number:
**PCT/JP2014/080043**

(87) International publication number:
**WO 2015/118744 (13.08.2015 Gazette 2015/32)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **06.02.2014 JP 2014021689**

(71) Applicant: **Kabushiki Kaisha Toshiba**
**Minato-ku**
**Tokyo 105-8001 (JP)**

(72) Inventors:
• **KATAYAMA, Kyosuke**
**Tokyo 105-8001 (JP)**
• **WADA, Takahisa**
**Tokyo 105-8001 (JP)**

• **KUBOTA, Kazuto**
**Tokyo 105-8001 (JP)**
• **SUYAMA, Akihiro**
**Tokyo 105-8001 (JP)**
• **NAGAIWA, Akihiro**
**Tokyo 105-8001 (JP)**
• **MATSUE, Kiyotaka**
**Tokyo 105-8001 (JP)**
• **TAIRA, Hiroshi**
**Tokyo 105-8001 (JP)**
• **YAMAGISHI, Masayuki**
**Tokyo 105-8001 (JP)**

(74) Representative: **Moreland, David**
**Marks & Clerk LLP**
**Aurora**
**120 Bothwell Street**
**Glasgow G2 7JS (GB)**

(54) **ENERGY MANAGEMENT SYSTEM**

(57) An energy management system (EMS) according to an embodiment has an EMS functional system which estimates at least one parameter value indicating a property of a power conditioner device. The functional system estimates at least one parameter value indicating a property of the power conditioner device on the basis of measured values of the power conditioner device for converting a DC power to an AC power to output the AC power to a power distribution system, the DC power having been inputted from a power generator or the power storage device.

FIG. 2

EP 3 104 488 A1

**Description**

[Technical Field]

Embodiments of the present invention relate to an energy management system.

[Background Art]

An energy management system (hereinafter referred to as an EMS) which controls a hybrid power conditioner system (hereinafter referred to as a hybrid PCS) in accordance with an energy use amount of power or the like in a building, a house, and a multiple dwelling house and reduces $CO_2$ and bought power has become widespread. In a hybrid PCS, a solar cell (a solar photovoltaic; hereinafter referred to as a PV) is connected to a storage battery through a direct current (DC) circuit, and a common controller controls a charge-discharge amount of the storage battery. Thus, the PV and the storage battery are regarded as being one alternating current (AC) power source in which a PV and a storage battery are integrally formed from the outside. For this reason, it is difficult for an EMS to accurately estimate each of properties of a hybrid PCS which are changed in real time.

[Citation List]

[Patent Literature]

[Patent Literature 1]
Japanese Unexamined Patent Application, First Publication No. 2011-70927

[Summary of Invention]

[Technical Problem]

An object to be accomplished by the present invention is to provide an energy management system (EMS) capable of more accurately estimating each of property parameters which are changed in real time in a hybrid power conditioner system (PCS).

[Solution to Problem]

An energy management system (EMS) according to an embodiment has an EMS functional system which estimates at least one parameter value indicating a property of a power conditioner device. The functional system estimates at least one parameter value indicating a property of the power conditioner device on the basis of measured values of the power conditioner device for converting a DC power to an AC power to output the AC power to a power distribution system, the DC power having been inputted from a power generator or the power storage device.

[Brief Description of Drawings]

Fig. 1 is a view showing a device arrangement of an entire system including an energy management system (EMS) in an embodiment.
Fig. 2 is a view showing a constitution of an EMS in an embodiment.
Fig. 3 is a flowchart showing a calculation procedure of a power storage device charge-discharge amount (performance) in a power storage device charge-discharge amount calculating functional section.
Fig. 4 is a flowchart showing a calculation procedure of a power storage device charge-discharge loss in a hybrid power conditioner system (PCS) property learning functional section.
Fig. 5 is a flowchart showing a calculation procedure of a PCS charge-discharge amount (planned) in the hybrid PCS property learning functional section.
Fig. 6 is a view showing an example of a PCS charge-discharge amount plan value serving as an output of a generation/storage optimizing functional section.

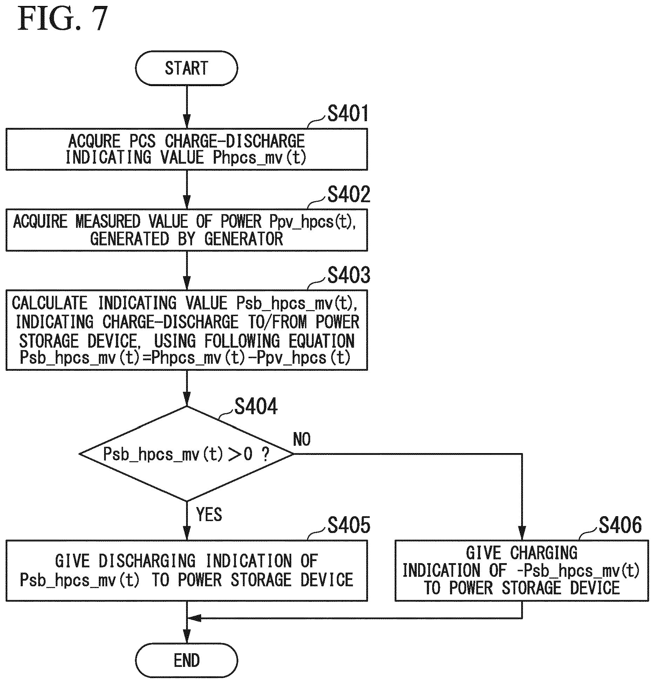

Fig. 7 is a flowchart showing an operational procedure of a hybrid PCS cooperating with an EMS.

[Description of Embodiments]

Hereinafter, an energy management system (EMS) in an embodiment will be described with reference to the drawings.

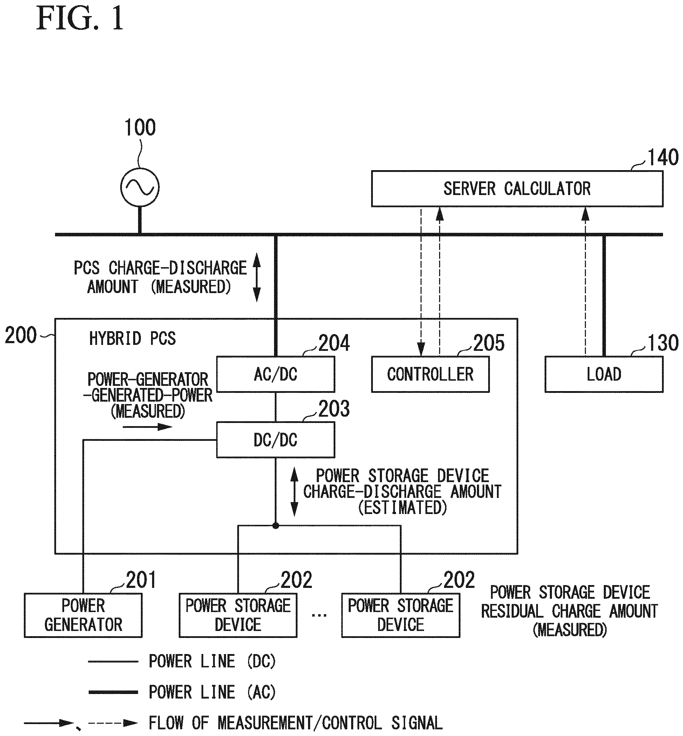

Fig. 1 is a view showing a device arrangement of an entire system including an EMS in an embodiment. The system shown in Fig. 1 includes a power distribution system 100, a load 130, a power generator 201, power storage devices 202, a server calculator 140, and a hybrid power conditioner system (PCS) 200.

The power distribution system 100 is a power distribution system of a building, a multiple dwelling house, a house, etc.

The load 130 is connected to the power distribution system 100 through alternating current (AC) power lines (an AC circuit) which transmit AC power.

The power generator 201 and the power storage devices 202 are each connected to the hybrid PCS 200 through direct current (DC) power lines (a DC circuit) which transmit DC power. The power generator 201 may be any power generator and is not limited to a specific power generator. For example, the power generator 201 may be a photovoltaic (PV) (a solar cell), a fuel cell device, and a solar thermal power generator. Also, the power storage device 202 may be any power storage device and is not limited to a specific power storage device. The power storage device 202 may be, for example, a storage battery and a flywheel power storage device.

The server calculator 140 serves as the EMS in the embodiment. The server calculator 140 can be configured as a plurality of calculator groups and may be one calculator.

The hybrid PCS 200 includes a DC/DC converter (hereinafter referred to as a DC/DC) 203, an AC/DC converter (hereinafter referred to as an AC/DC) 204, and a controller 205.

The hybrid PCS 200 performs stepping up/down of a voltage, stabilizing, current controlling, opening/closing of a circuit, protecting cooperation, etc. for DC power of power generated in the power generator 201 and charged-discharged in the power storage device 202.

The DC/DC 203 boosts a DC voltage of the power generator 201 and inputs the DC voltage to the AC/DC 204 through DC power lines. Alternatively, the DC/DC 203 inputs DC voltages from the power storage device 202 to the AC/DC 204 through DC power lines or steps down a DC voltage from the AC/DC 204 and inputs the DC voltage to the power storage device 202 through DC power lines.

The AC/DC 204 converts AC power input through AC power lines from the power distribution system 100 into DC power and inputs the converted DC power to the DC/DC 203 through DC power lines. The AC/DC 204 converts DC power input through DC power lines from the DC/DC 203 into AC power and outputs the converted AC power to the power distribution system 100 through AC power wires. The AC/DC 204 links the power generator 201 and the power storage device 202 to the power distribution system 100 as described above.

As described above, the hybrid PCS 200 is a power conditioner device which connects the power generator 201, the power storage device 202, and the DC/DC through the DC power lines and in which the AC/DC 204 (a bidirectional DC/AC inverter) is used by all of the devices.

The controller 205 can mutually communicate with the server calculator 140 serving as the EMS and controls the entire hybrid PCS 200. The controller 205 estimates power storage device charge-discharge amounts (estimated) in accordance with a power-generator-generated-power (measured) and at least one of a charging indication, a discharging indication, a charge amount indicating value, and a discharge amount indicating value transmitted from the server calculator 140, and controls a charge-discharge amount of the power storage device 202 on the basis of the estimated result (details will be described below).

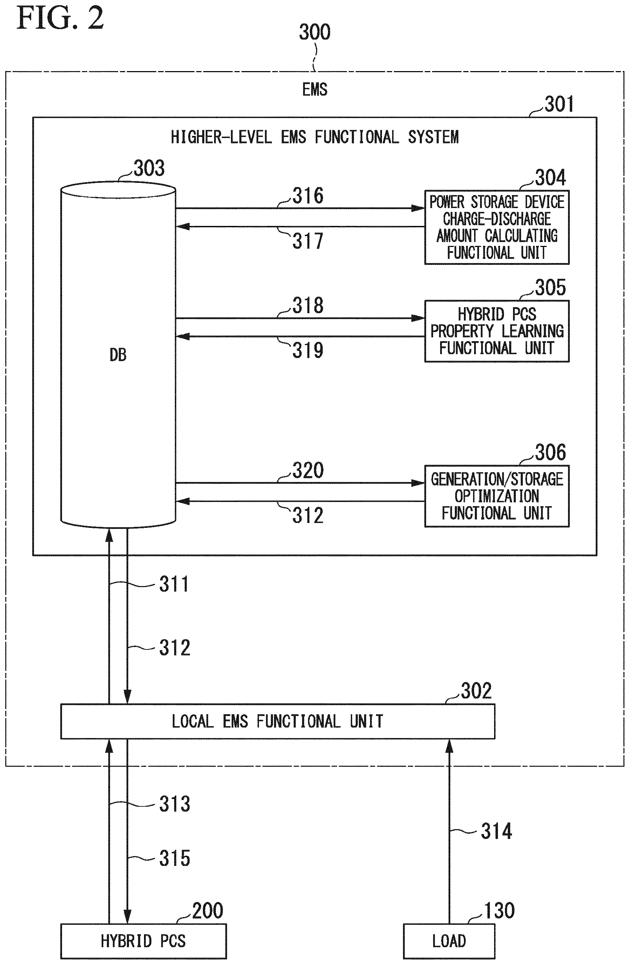

Fig. 2 is a view showing a constitution of an EMS in an embodiment. An EMS 300 is configured as higher-level EMS functional systems 301 (an EMS server) and local EMS functional units 302. In the EMS in the embodiment, the higher-level EMS functional systems 301 and the local EMS functional units 302 are each disposed in a plurality of calculators in a distributed manner. The local EMS functional unit 302 is configured as a section corresponding to a local calculator installed in a building, a multiple dwelling house, and a house, and the higher-level EMS functional systems 301 is configured as a section corresponding to a calculator in a cloud system or a data center connected to a local calculator over a public communication circuit network such as the Internet. The higher-level EMS functional systems 301 includes a database (hereinafter referred to as a DB) 303, a power storage device charge-discharge amount calculating functional unit 304, a hybrid PCS property learning functional unit 305, and a generation/storage optimization functional unit 306.

The local EMS functional unit 302 receives measured values 313 (a power-generator-generated-power (measured), a PCS charge-discharge amount (measured), and a power storage device residual charge amount (measured)) from the controller 205 of the hybrid PCS 200. Also, the local EMS functional unit 302 receives a power demand (measured) 314 serving as a measured value of a power demand consumed by the load 130 from a power measurement system provided for the load 130. The local EMS functional unit 302 stores this data as performance values, and transmits the performance values as performance values 311 (a power-generator-generated-power (performance), a PCS charge-discharge amount (performance), a power storage device residual charge amount (performance), and a power demand (performance)) to the higher-level EMS functional systems 301 in a predetermined period or when there is a request from the higher-level EMS functional systems 301. The local EMS functional unit 302 transmits a PCS charge-discharge amount (indicated) 315 to the controller 205 of the hybrid PCS 200 using a PCS charge-discharge amount (planned) 312 serving as a plan of a PCS charge-discharge amount received from the higher-level EMS functional systems 301 as an indication value of the PCS charge-discharge amount to the hybrid PCS 200 in a predetermined period or at a time at which there is a request from the hybrid PCS 200.

The higher-level EMS functional systems 301 receives the performance values 311 (the power-generator-generated-power (the performance), the PCS charge-discharge amount (the performance), the power storage device residual charge amount (the performance), and the power demand (the performance)) from the local EMS functional unit 302 using data communication and stores the performance value 311 in the DB 303. Also, the higher-level EMS functional systems 301 performs each calculation process in the power storage device charge-discharge amount calculating functional unit 304, the hybrid PCS property learning functional unit 305, and the generation/storage optimization functional unit 306 and transmits the PCS charge-discharge amount (planned) 312 serving as the plan of the PCS charge-discharge amount to the local EMS functional unit 302 (details will be described below).

The DB 303 stores the performance value 311 and the PCS charge-discharge amount (planned) 312 which are transmitted and received between the DB 303 and the local EMS functional unit 302. Also, the DB 303 delivers various performance values and calculation results in accordance with a request from the power storage device charge-discharge amount calculating functional unit 304, the hybrid PCS property learning functional unit 305, and the generation/storage optimization functional unit 306.

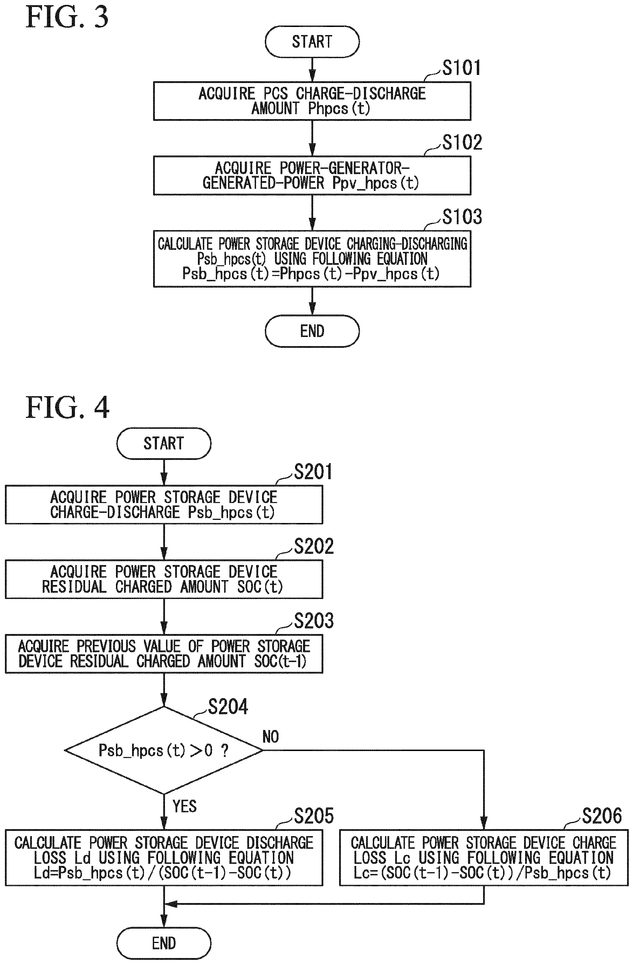

The power storage device charge-discharge amount calculating functional unit 304 reads performance values 316 serving as performance values of a power-generator-generated-power (performance), a PCS charge-discharge amount (performance), and a power storage device residual charge amount (performance) from the DB 303. The power storage device charge-discharge amount calculating functional unit 304 estimates and calculates a power storage device charge-discharge amount (performance) 317 serving as a performance value of a power storage device charge-discharge amount which cannot be acquired from the hybrid PCS 200 on the basis of the data and writes the power storage device charge-discharge amount (performance) 317 to the DB 303. Note that a calculation procedure thereof will be described below in accordance with a flowchart shown in Fig. 3.

The hybrid PCS property learning functional unit 305 reads performance values 318 serving as performance values of a power storage device residual charge amount (performance) and a power storage device charge-discharge amount (performance) 317 calculated by the power storage device charge-discharge amount calculating functional unit 304 from the DB 303. The hybrid PCS property learning functional unit 305 estimates and calculates a power storage device charge-discharge loss 319 serving as a charge-discharge loss of the power storage device serving as a type of property parameter of the hybrid PCS 200 on the basis of the data. The hybrid PCS property learning functional unit 305 writes the power storage device charge-discharge loss 319 to the DB 303. Note that the calculation procedure will be described below in accordance with a flowchart shown in Fig. 4.

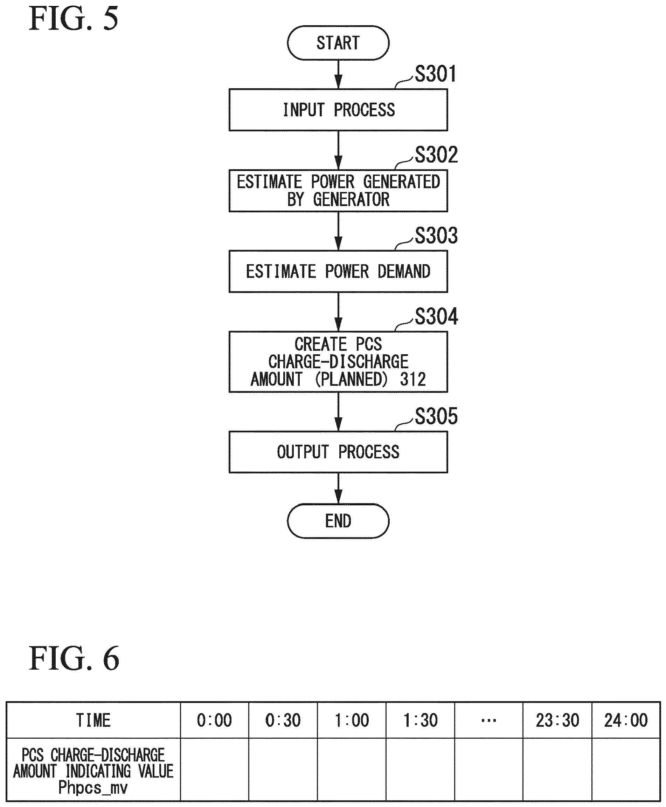

The generation/storage optimization functional unit 306 reads performance values 320 (a power-generator-generated-power (performance), a power demand (performance), a power storage device residual charge amount (performance), the power storage device charge-discharge amount (performance) 317 estimated and calculated by the power storage device charge-discharge amount calculating functional unit 304, and the power storage device charge-discharge loss 319 estimated and calculated by the hybrid PCS property learning functional section 305) from the DB 303. The generation/storage optimization functional unit 306 calculates the PCS charge-discharge amount (planned) 312 serving as a plan of the PCS charge-discharge amount on the basis of the data and writes the calculated PCS charge-discharge amount (planned) 312 to the DB 303. Note that a calculation procedure thereof will be described below in accordance with a flowchart shown in Fig. 5.

Next, a calculation procedure of the power storage device charge-discharge amount (performance) 317 in the power storage device charge-discharge amount calculating functional unit 304 will be described.

Fig. 3 is a flowchart showing a calculation procedure of the power storage device charge-discharge amount (performance) 317 in the power storage device charge-discharge amount calculating functional unit 304. Note that the calculation procedure will be described using the following variables.

A performance value at a time t of a PCS charge-discharge amount (performance) included in the performance values 316 is set as $Phpcs(t)$. Also, a performance value at the time t of a power-generator-generated-power (performance) included in the performance values 316 is set as $Ppv\_hpcs(t)$. A performance value at the time t of the calculated power storage device charge-discharge amount (performance) 317 is set as $Psb\_hpcs(t)$.

The power storage device charge-discharge amount calculating functional unit 304 acquires $Phpcs(t)$ serving as a performance value at the time of a PCS charge-discharge amount (performance) from the DB 303 (step S101).

The power storage device charge-discharge amount calculating functional unit 304 acquires $Ppv\_hpcs(t)$ serving as a power-generator-generated-power (performance) from the DB 303 (step S102).

The power storage device charge-discharge amount calculating functional unit 304 estimates and calculates Psb_hpcs(t) serving as a performance value at the time t of the power storage device charge-discharge amount (performance) 317 using the following Equation (1) (step S103).

$$Psb\_hpcs(t) = Phpcs(t)-Ppv\_hpcs(t) \qquad Equation\ (1)$$

Psb_hpcs(t) serving as a result of this estimation calculation is written as the power storage device charge-discharge amount (performance) 317 to the DB 303. The hybrid PCS property learning functional unit 305 reads the power storage device charge-discharge amount (performance) 317 and uses the power storage device charge-discharge amount (performance) 317 in a calculation in which the power storage device charge-discharge loss 319 are estimated.

Next, a calculation procedure of the power storage device charge-discharge loss 319 in the hybrid PCS property learning functional unit 305 will be described.

Fig. 4 is a flowchart showing a calculation procedure of the power storage device charge-discharge loss 319 in the hybrid PCS property learning functional unit 305. Note that the calculation procedure will be described using the following variables.

A performance value at the time t of a power storage device residual charge amount (performance) included in the performance value 318 is set as SOC(t). Also, in the power storage device charge-discharge loss 319 to be calculated, a power storage device discharge loss at the time t is set as Ld(t), and a power storage device charge loss at the time t is set as Lc(t).

The power storage device charge-discharge amount calculating functional unit 304 acquires a performance value Psb_hpcs(t) at the time t of the power storage device charge-discharge amount (performance) 317 included in the performance values 318 from the DB 303 (step S201).

Next, the power storage device charge-discharge amount calculating functional unit 304 acquires a performance value SOC(t) at the time t of the power storage device residual charge amount (performance) included in the performance value 318 from the DB 303 (step S202).

Next, the power storage device charge-discharge amount calculating functional unit 304 acquires a performance value SOC(t-1) at a time which is a predetermined time prior to the time t of a power storage device residual charge amount (performance) included in the performance values 318 from the DB 303 (step S203). Note that the performance value SOC(t-1) at the time which is the predetermined time prior to the time is a performance value SOC of a power storage device residual charge amount (performance) when the power storage device charge-discharge amount calculating functional unit 304 previously calculates the power storage device charge-discharge loss 319.

Next, the power storage device charge-discharge amount calculating functional unit 304 determines whether a performance value Psb_hpcs(t) at the time t of the power storage device charge-discharge amount (performance) 317 is greater than 0 (step S204).

In step S204, when Psb_hpcs(t) > 0 (Yes in step S204), the power storage device charge-discharge amount calculating functional unit 304 estimates and calculates a power storage device discharge loss Ld(t) using the following Equation (2) (step S205).

$$Ld(t) = Psb\_hpcs(t)/(SOC(t-1)-SOC(t)) \qquad Equation\ (2)$$

In other words, the power storage device discharge loss Ld(t) is a parameter value indicating a power loss when the power storage device 202 of the hybrid PCS 200 is discharged, which is a value obtained by dividing a discharge amount estimated value by a reduction amount of a residual charge amount of the power storage device 202.

On the other hand, in step S204, when Psb_hpcs(t) ≤ 0 (No in step S204), the power storage device charge-discharge amount calculating functional unit 304 estimates and calculates a power storage device charge loss Lc(t) using the following Equation (3) (step S206).

$$Lc(t) = (SOC(t-1)-SOC(t))/Psb\_hpcs(t) \qquad Equation\ (3)$$

In other words, the power storage device charge loss Lc(t) is a parameter value indicating a power loss when the power storage device 202 of the hybrid PCS 200 is charged, which is a value obtained by dividing an increase amount of a residual charge amount of the power storage device 202 by a charge amount estimated value.

Ld(t) and Lc(t) serving as results of these estimation calculations are written as the power storage device charge-discharge loss 319 to the DB 303. The generation/storage optimization functional unit 306 reads the performance values 320 including the power storage device charge-discharge loss 319 and calculates the PCS charge-discharge amount (planned) 312 serving as a plan of the PCS charge-discharge amount.

As described above, the EMS 300 in the embodiment has a function of estimating a parameter value indicating each of properties of the hybrid PCS 200 (Lc(t); a value indicating a size of a power loss when the power storage device 202 is charged and Lc(t); a value indicating a size of power loss when the power storage device 202 is discharged) on the basis of a measured value of the hybrid PCS 200. Thus, in the EMS 300 in the embodiment, an energy management system capable of accurately estimating each of property parameters which are changed in real time, which were difficult to accurately ascertain in the related art, in the hybrid PCS 200 can be provided.

Next, a calculation procedure of the PCS charge-discharge amount (planned) 312 in the generation/storage optimization functional unit 306 will be described. Fig. 5 is a flowchart showing a calculation procedure of the PCS charge-discharge amount (planned) 312 in the hybrid PCS property learning functional unit 305.

The generation/storage optimization functional unit 306 performs an input process (step S301). The generation/storage optimization functional unit 306 reads the performance values 320 from the DB 303.

Next, the generation/storage optimization functional unit 306 performs a power generator power generation estimation (step S302). The generation/storage optimization functional unit 306 estimates a power-generator-generated-power in a target day using a particular previous power-generator-generated-power (performance), a weather forecast, etc. Since a weather forecast is needed to calculate a power-generator-generated-power estimate value, the power-generator-generated-power estimate value is calculated several times a day when the weather forecast is delivered. The power-generator-generated-power estimate value can be implemented using a well-known method such as, for example, that is, an estimation method based on a statistical correlation between different times in past data or a statistical correlation between positions of different power generators.

Next, the generation/storage optimization functional unit 306 performs a power demand estimation (step S303). The generation/storage optimization functional unit 306 performs a power demand estimation using an estimation method using a neural network from a weather forecast and past demand data or an estimation method using a demand variation model in which past demand data of a plurality of target demand objects are grouped and averaged for every group, and calculates a power demand estimated value.

Next, the generation/storage optimization functional unit 306 creates the PCS charge-discharge amount (planned) 312 serving as a PCS charging-discharging plan (step S304). An example of a creation technique includes a technique of using a genetic algorithm, a technique in which a reduction in utility costs can be expected when a charging-discharging rule of a power storage device for the purpose of reducing utility costs is created and a deviation occurs between an estimated value and an actual value from a power generator power generation estimated value and a power demand estimated value, etc. The generation/storage optimization functional unit 306 writes the created PCS charge-discharge amount (planned) 312 to the DB 303.

Fig. 6 is a view showing an example of a PCS charge-discharge amount plan value serving as an output of the generation/storage optimization functional unit 306. A PCS charge-discharge amount indicating value Phpcs_mv in the hybrid PCS 200 is associated with a time at which the generation/storage optimization functional unit 306 performs writing on the DB 303 and is written as a PCS charge-discharge amount plan value to the PCS charge-discharge amount (planned) 312.

The local EMS functional unit 302 transmits the PCS charge-discharge amount (planned) 312 to the controller 205 of the hybrid PCS 200 using the charge-discharge amount indicating value Phpcs_mv as the PCS charge-discharge amount (indicated) 315 in a predetermined period or at a time at which there is a request from the hybrid PCS 200.

As described above, the EMS 300 in the embodiment can give a charge-discharge amount indicating value Phpcs_mv to the hybrid PCS 200 (at least one of a charging indication, a discharging indication, a charge amount indicating value, and a discharge amount indicating value) on the basis of estimated results of parameter values of the hybrid PCS 200.

The controller 205 estimates a power storage device charge-discharge amount (estimated) indicating a charge-discharge amount of the power storage device 202 on the basis of a charge-discharge amount indicating value Phpcs_mv and a power-generator-generated-power (measured) which is included in the measured values 313 when receiving the PCS charge-discharge amount (indicated) 315 and controls charging-discharging of the power storage device 202 on the basis of the estimated result.

Subsequently, an operation of the controller 205 which controls the entire hybrid PCS 200 when the PCS charge-discharge amount (indicated) 315 is received from the local EMS functional unit 302 will be described. Fig. 6 is a flowchart showing an operation procedure of the hybrid PCS 200 cooperating with the EMS 300. The procedure will be described using the following variables. Note that a calculation procedure will be described using the following variables. An indication value of a PCS charge-discharge amount at the time t is set as Phpcs_mv(t). Also, a power storage device charge-discharge indication value at the time t is set as Psb_hpcs_mv(t).

The controller 205 receives the indicated value Phpcs_mv(t) of the PCS charge-discharge amount from the local EMS functional unit 302 (step S401).

Next, the controller 205 acquires a power-generator-generated-power measurement value Ppv_hpcs(t) from the power generator 201 (step S402).

The controller 205 calculates a power storage device charge-discharge indicating value Psb_hpcs_mv(t) using the following Equation (4) (step S403).

$$\text{Psb\_hpcs\_mv(t)} = \text{Phpcs\_mv(t)} - \text{Ppv\_hpcs(t)} \qquad \text{Equation (4)}$$

The controller 205 determines whether the power storage device charge-discharge indicating value Psb_hpcs_mv(t) is greater than 0 at the time t (step S404).

The controller 205 sets a discharge amount estimated value of the power storage device 202 to be Psb_hpcs_mv(t) when Psb_hpcs_mv(t) > 0 (Yes in step S404) and discharges a discharge amount corresponding to Psb_hpcs_mv(t) from the power storage device 202.

For example, when the indicated value Phpcs_mv(t) of the PCS charge-discharge amount serving as a discharge amount of the hybrid PCS 200 is 1000 W (watts) and the power-generator-generated-power measurement value Ppv_hpcs(t) is 100 W, Psb_hpcs_mv(t) = 1000 W-100 W = 900 W based on Equation (4). In other words, the discharge amount estimated value of the power storage device 202 is a value obtained by subtracting 100 W serving as a generated-power amount performance value of the power generator 201 from 1000 W serving as a discharge indicating value from the power conditioner device. The controller 205 sets 900 W corresponding to the discharge amount estimated value of the power storage device 202 to be a discharge amount of 900 W, and controls the power storage device 202 to discharge the discharge amount of 900 W from the power storage device 202.

On the other hand, the controller 205 sets the charge amount estimate value of the power storage device 202 to be (-Psb_hpcs_mv(t)) when Psb_hpcs_mv(t) ≤ 0 (No in step S404) and charges a charge amount corresponding to (-Psb_hpcs_mv(t)) to the power storage device 202.

For example, when the indicating value Phpcs_mv(t) of the PCS charge-discharge amount serving as a charge amount in the hybrid PCS 200 is 1000 W (watts), and the power-generator-generated-power measurement value Ppv_hpcs(t) is 100 W, Psb_hpcs_mv(t) = -1000 W-100 W = -1100W on the basis of Equation (4) is satisfied. In other words, the charge amount estimated value to the power storage device 202 is a value obtained by adding 1000 W serving as a charge indicating value to the power conditioner device and 100 W serving as the generated-power performance value of the power generator 201. The controller 205 sets 1100 W corresponding to the charge amount estimated value of the power storage device 202 to be a charge amount of 1100 W, and controls the power storage device 202 to charge the charge amount of 1100 W to the power storage device 202.

Also, for example, when the indicating value Phpcs_mv(t) of the PCS charge-discharge amount serving as a discharge amount from the hybrid PCS 200 is 1000 W (watts), and the power-generator-generated-power measurement value Ppv_hpcs(t) is 1100 W, Psb_hpcs_mv(t) = 1000 W-1100 W = -100W from Equation (4) is satisfied. In other words, the charge amount estimated value of the power storage device 202 is a value obtained by subtracting 1000 W serving as a discharge indicating value from the power conditioner device from 1100 W serving as the generated-power performance value of the power generator 201. The controller 205 sets 100 W corresponding to the charge amount estimated value of the power storage device 202 to be a charge amount of 100 W and controls the power storage device 202 to charge the charge amount of 100 W to the power storage device 202.

As described above, in the EMS 300 in the embodiment, in the EMS 300 in the embodiment, the charge-discharge amount indicating value Phpcs_mv (at least one or more of the charging indication, the discharging indication, the charge amount indicating value, and the discharge amount indicating value) is given to the hybrid PCS 200 on the basis of an estimated result of a parameter value of the hybrid PCS 200. The hybrid PCS 200 controls the charge-discharge amount of the power storage device 202 in accordance with a generated-power of the power generator 201 and at least one or more of a charging indication, a discharging indication, a charge amount indicating value, and a discharge amount indicating value from the EMS 300.

In an EMS in the related art, a generated-power of a power generator which is measured inside a hybrid PCS can be acquired from the outside, but a charge-discharge amount to a power storage device cannot be acquired from the outside. Therefore, in the EMS in the related art, the charge-discharge amount to the power storage device needs to be estimated and calculated from the generated-power of the power generator, a charge-discharge measurement value of the hybrid PCS, and property parameters of the hybrid PCS such as a performance value of the charge-discharge amount of the power storage device. However, since a performance value of the charge-discharge amount of the power storage device is not recognized and cannot be acquired from the outside, there is a need to use an estimated value of the charge-discharge amount of the power storage device as the property parameter of the hybrid PCS. Usage of property data of the power storage device when a product is shipped is considered as an estimated value of a charge-discharge amount of the power storage device, but when a power storage device having a variation in properties is used, the properties are not necessarily consistent to property parameters of the entire hybrid PCS in some cases. This is because property data of each power storage device such as a capacity or a loss is generally changed according to a usage environment, a usage frequency, or a usage period. For this reason, even if property data of a power storage device when a product is shipped is known, a gap between property data of the power storage device when the product is shipped and property data of the power storage device which is actually being operated is gradually increased while the hybrid PCS is being used. For the above reasons, it was difficult to accurately estimate each of property parameters of the hybrid PCS which are changed in real time in the EMS in the related art.

On the other hand, in the EMS 300 in the embodiment, it is possible to accurately estimate a property parameter which is changed in real time, which was difficult to accurately ascertain in the related art, in the hybrid PCS 200. Also, an energy management system capable of preventing the occurrence of overcharge or overdischarge of a power storage device constituting the hybrid PCS 200 using the estimation result, that is, of optimally controlling the hybrid PCS 200, can be provided.

According to at least one of the embodiments described above, an energy management system which includes a function of estimating at least one parameter value indicating a property of the hybrid PCS on the basis of measured values in the hybrid PCS so that a property parameter which is changed in real time in a hybrid PCS which commonly uses a bidirectional DC/AC inverter can be more accurately estimated can be provided.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1.  An energy management system comprising:

    an EMS functional system configured to estimate at least one parameter value indicating a property of a power conditioner device on the basis of measured values of the power conditioner device for converting a DC power to an AC power to output the AC power to a power distribution system, the DC power having been inputted from a power generator or the power storage device.

2.  The energy management system according to claim 1, further comprising:

    a local EMS functional unit configured to give at least one of a charging indication, a discharging indication, a charge amount indicating value, and a discharge amount indicating value to the power conditioner device on the basis of the estimated result of the parameter value, and
    wherein the power conditioner device controls a charge-discharge amount of the power storage device in accordance with a generated-power of the power generator and at least one of the charging indication, the discharging indication, the charge amount indication value, and the discharge amount indication value.

3.  The energy management system according to claim 1 or 2, comprising:

    a generation/storage optimization unit which calculates a charge amount indicating value to the power conditioner device.

4.  The energy management system according to any one of claims 1 to 3, comprising:

    the generation/storage optimization unit which calculates the charge amount indicating value to the power conditioner device.

5.  The energy management system according to any one of claims 1 to 4, wherein at least one of parameters indicating the properties of the power conditioner device is a value indicating a size of a power loss when the power storage device is charged.

6.  The energy management system according to any one of claims 1 to 5, wherein at least one of the parameters indicating the properties of the power conditioner device is a value indicating a size of a power loss when the power storage device is discharged.

7. The energy management system according to any one of claims 2 to 6, comprising:

the generation/storage optimization unit which calculates at least one of the charging indication, the discharging indication, the charge amount indicating value, and the discharge amount indicating value given to the power conditioner device on the basis of a generated-power estimated value of the power generator.

8. The energy management system according to any one claims 2 to 7, comprising:

the generation/storage optimization unit which calculates at least one of the charging indication, the discharging indication, the charge amount indicating value, and the discharge amount indicating value given to the power conditioner device on the basis of a power demand estimated value for a target demand object.

9. The energy management system according to any one of claims 1 to 8, wherein the power conditioner device includes a learning functional unit which estimates a charge amount of a connected power storage device.

10. The energy management system according to any one of claims 1 to 9, wherein the power conditioner device includes the learning functional unit which estimates a discharge amount of the connected power storage device.

11. The energy management system according to claim 9 or 10, wherein a charge amount estimated value of the power storage device connected to the power conditioner device is a value obtained by adding a charge indicating value to the power conditioner device and a generated-power performance value of the power generator.

12. The energy management system according to claim 9 or 10, wherein a charge amount estimated value of the power storage device connected to the power conditioner device is a value obtained by subtracting a discharge indicating value to the power conditioner device from a generated-power performance value of the power generator.

13. The energy management system according to claim 10, wherein a discharge amount estimated value of the power storage device connected to the power conditioner device is a value obtained by subtracting a generated-power performance value of the power generator from a discharge indicating value to the power conditioner device.

14. The energy management system according to any one of claims 2 to 13, wherein a parameter value indicating the power loss when the power storage device of the power conditioner device is charged is a value obtained by dividing an increase amount of a residual charged amount of the power storage device by the charge amount estimated value.

15. The energy management system according to any one of claims 2 to 14, wherein a parameter value indicating the power loss when the power storage device of the power conditioner device is discharged is a value obtained by dividing the discharge amount estimated value by a decrease amount of the residual charged amount of the power storage device.

FIG. 1

FIG. 2

300

EMS

301

HIGHER-LEVEL EMS FUNCTIONAL SYSTEM

303

DB

316

317

POWER STORAGE DEVICE CHARGE-DISCHARGE AMOUNT CALCULATING FUNCTIONAL UNIT

304

318

319

HYBRID PCS PROPERTY LEARNING FUNCTIONAL UNIT

305

320

312

GENERATION/STORAGE OPTIMIZATION FUNCTIONAL UNIT

306

311

312

LOCAL EMS FUNCTIONAL UNIT

302

313

315

314

HYBRID PCS

200

LOAD

130

## FIG. 3

```
                    ┌─────────┐
                    │  START  │
                    └────┬────┘
                         │              S101
            ┌────────────▼──────────────┐
            │  ACQUIRE PCS CHARGE-DISCHARGE │
            │      AMOUNT Phpcs(t)          │
            └────────────┬──────────────┘
                         │              S102
            ┌────────────▼──────────────┐
            │   ACQUIRE POWER-GENERATOR-  │
            │  GENERATED-POWER Ppv_hpcs(t)│
            └────────────┬──────────────┘
                         │              S103
   ┌─────────────────────▼─────────────────────┐
   │ CALCULATE POWER STORAGE DEVICE CHARGING-DISCHARGING │
   │    Psb_hpcs(t) USING FOLLOWING EQUATION     │
   │    Psb_hpcs(t)=Phpcs(t)-Ppv_hpcs(t)         │
   └─────────────────────┬─────────────────────┘
                         │
                    ┌────▼────┐
                    │   END   │
                    └─────────┘
```

$$Psb\_hpcs(t)=Phpcs(t)-Ppv\_hpcs(t)$$

## FIG. 4

```
                    ┌─────────┐
                    │  START  │
                    └────┬────┘
                         │              S201
            ┌────────────▼──────────────┐
            │  ACQUIRE POWER STORAGE DEVICE │
            │   CHARGE-DISCHARGE Psb_hpcs(t)│
            └────────────┬──────────────┘
                         │              S202
            ┌────────────▼──────────────┐
            │  ACQUIRE POWER STORAGE DEVICE │
            │  RESIDUAL CHARGED AMOUNT SOC(t)│
            └────────────┬──────────────┘
                         │              S203
            ┌────────────▼──────────────┐
            │ ACQUIRE PREVIOUS VALUE OF POWER STORAGE │
            │ DEVICE RESIDUAL CHARGED AMOUNT SOC(t-1) │
            └────────────┬──────────────┘
                         │              S204
                    ◇────▼────◇      NO
                  ◇  Psb_hpcs(t)>0 ? ◇──────────────┐
                    ◇─────────◇                     │
                         │ YES                       │
                    S205 │                      S206 │
   ┌─────────────────────▼──────────┐  ┌─────────────▼────────────────┐
   │ CALCULATE POWER STORAGE DEVICE DISCHARGE │  │ CALCULATE POWER STORAGE DEVICE CHARGE │
   │   LOSS Ld USING FOLLOWING EQUATION │  │  LOSS Lc USING FOLLOWING EQUATION │
   │ Ld=Psb_hpcs(t)/(SOC(t-1)-SOC(t))   │  │ Lc=(SOC(t-1)-SOC(t))/Psb_hpcs(t)  │
   └─────────────────────┬──────────┘  └─────────────┬────────────────┘
                         │◄──────────────────────────┘
                    ┌────▼────┐
                    │   END   │
                    └─────────┘
```

$$Ld=Psb\_hpcs(t)/(SOC(t-1)-SOC(t))$$

$$Lc=(SOC(t-1)-SOC(t))/Psb\_hpcs(t)$$

## FIG. 5

```
        ( START )
            │
            ▼           ⟋S301
    ┌───────────────────┐
    │   INPUT PROCESS   │
    └───────────────────┘
            │
            ▼           ⟋S302
    ┌───────────────────┐
    │ ESTIMATE POWER GENERATED │
    │     BY GENERATOR  │
    └───────────────────┘
            │
            ▼           ⟋S303
    ┌───────────────────┐
    │ ESTIMATE POWER DEMAND │
    └───────────────────┘
            │
            ▼           ⟋S304
    ┌───────────────────┐
    │     CREATE PCS    │
    │  CHARGE-DISCHARGE │
    │ AMOUNT (PLANNED) 312 │
    └───────────────────┘
            │
            ▼           ⟋S305
    ┌───────────────────┐
    │   OUTPUT PROCESS  │
    └───────────────────┘
            │
            ▼
        (  END  )
```

## FIG. 6

| TIME | 0:00 | 0:30 | 1:00 | 1:30 | ··· | 23:30 | 24:00 |
|---|---|---|---|---|---|---|---|
| PCS CHARGE-DISCHARGE AMOUNT INDICATING VALUE Phpcs_mv | | | | | | | |

# FIG. 7

```
                    ┌─────────┐
                    │  START  │
                    └────┬────┘
                         │
                         ▼                         ╭─S401
    ┌────────────────────────────────────────┐
    │   ACQURE PCS CHARGE-DISCHARGE           │
    │   INDICATING VALUE Phpcs_mv(t)          │
    └────────────────┬───────────────────────┘
                     │                            ╭─S402
    ┌────────────────▼───────────────────────┐
    │ ACQUIRE MEASURED VALUE OF POWER Ppv_hpcs(t), │
    │         GENERATED BY GENERATOR          │
    └────────────────┬───────────────────────┘
                     │                            ╭─S403
    ┌────────────────▼───────────────────────┐
    │ CALCULATE INDICATING VALUE Psb_hpcs_mv(t), │
    │ INDICATING CHARGE-DISCHARGE TO/FROM POWER  │
    │ STORAGE DEVICE, USING FOLLOWING EQUATION   │
    │ Psb_hpcs_mv(t)=Phpcs_mv(t)-Ppv_hpcs(t)     │
    └────────────────┬───────────────────────┘
                     │
                     ▼          ╭─S404
                  ╱─────────╲         NO
                ╱  Psb_hpcs_mv  ╲─────────────────┐
                ╲  (t)＞0 ?     ╱                  │
                  ╲─────────╱                      │
                     │                             │
                     │ YES                         │
                     ▼          ╭─S405             ▼          ╭─S406
    ┌────────────────────────────────┐   ┌──────────────────────────┐
    │   GIVE DISCHARGING INDICATION OF │   │     GIVE CHARGING        │
    │ Psb_hpcs_mv(t) TO POWER STORAGE  │   │ INDICATION OF -Psb_hpcs_mv(t) │
    │           DEVICE                 │   │   TO POWER STORAGE DEVICE │
    └────────────────┬───────────────┘   └──────────┬───────────────┘
                     │◄──────────────────────────────┘
                     ▼
                ┌─────────┐
                │   END   │
                └─────────┘
```

## INTERNATIONAL SEARCH REPORT

| International application No. |
|---|
| PCT/JP2014/080043 |

A.  CLASSIFICATION OF SUBJECT MATTER
*H02J3/32*(2006.01)i, *H02J13/00*(2006.01)i

According to International Patent Classification (IPC) or to both national classification and IPC

B.  FIELDS SEARCHED

Minimum documentation searched (classification system followed by classification symbols)
H02J3/32, H02J13/00

Documentation searched other than minimum documentation to the extent that such documents are included in the fields searched
Jitsuyo Shinan Koho          1922-1996    Jitsuyo Shinan Toroku Koho    1996-2015
Kokai Jitsuyo Shinan Koho    1971-2015    Toroku Jitsuyo Shinan Koho    1994-2015

Electronic data base consulted during the international search (name of data base and, where practicable, search terms used)

C.  DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2013-247843 A  (Kyocera Corp.),<br>09 December 2013 (09.12.2013),<br>entire text; all drawings<br>(Family: none) | 1,2,4,6,10,<br>13<br>1-13<br>14,15 |
| Y<br>A | JP 2008-141918 A  (Nippon Telegraph and<br>Telephone Corp.),<br>19 June 2008 (19.06.2008),<br>paragraphs [0030] to [0032]<br>(Family: none) | 7<br>1-6,8-15 |
| Y<br>A | JP 2001-327080 A  (The Kansai Electric Power<br>Co., Inc.),<br>22 November 2001 (22.11.2001),<br>paragraph [0032]<br>(Family: none) | 8<br>1-7,9-15 |

| ☒ | Further documents are listed in the continuation of Box C. | ☐ | See patent family annex. |
|---|---|---|---|

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>09 January 2015 (09.01.15) | Date of mailing of the international search report<br>20 January 2015 (20.01.15) |
|---|---|
| Name and mailing address of the ISA/<br>Japan Patent Office | Authorized officer |
| Facsimile No. | Telephone No. |

Form PCT/ISA/210 (second sheet) (July 2009)

**INTERNATIONAL SEARCH REPORT**

International application No.

PCT/JP2014/080043

C (Continuation). DOCUMENTS CONSIDERED TO BE RELEVANT

| Category* | Citation of document, with indication, where appropriate, of the relevant passages | Relevant to claim No. |
|---|---|---|
| Y<br>A | JP 10-201129 A (Japan Storage Battery Co., Ltd.),<br>31 July 1998 (31.07.1998),<br>paragraph [0024]<br>(Family: none) | 9-13<br>1-8,14,15 |
| Y<br>A | JP 2005-80475 A (The Tokyo Electric Power Co., Inc.),<br>24 March 2005 (24.03.2005),<br>paragraphs [0016], [0029] to [0036]<br>(Family: none) | 1-6,9-13<br>7,8,14,15 |

Form PCT/ISA/210 (continuation of second sheet) (July 2009)

**EP 3 104 488 A1**

**REFERENCES CITED IN THE DESCRIPTION**

**Patent documents cited in the description**

- JP 2011070927 A